# EUROPEAN PATENT APPLICATION

(11) **EP 1 193 752 A1**
(43) Date of publication of application: **03.04.2002**
(21) Application number: 00402680.3
(22) Date of filing: 28.09.2000
(51) Int. Cl.: H01L 21/762, H01L 21/20

(54) **Method to form a localized silicon-on-insulator structure**

(71) Applicant: MOTOROLA, INC., Schaumburg, IL 60196 (US)
(72) Inventor: Roux, Sylvie, 31130 Fonsegrives (FR); Dilhac, Jean-Marie, 31000 Toulouse (FR); Bafleur, Maryse, 31320 Castanet Tolosan (FR); Charitat, Georges, 46140 Saint-Vincent Rive D'Olt (FR); Pages, Irenée, 31270 Villeneuve Tolosane (FR)
(74) Representative: Joly, Jean-Jacques

(57) **Abstract**

A semiconductor device and method of fabrication using LEGO (Lateral Epitaxial Growth over Oxide) for forming a SOI (Silicon On Insulator) structure (FIG. 1) having a localized buried dielectric layer (2). By patterning the buried dielectric layer, covered with a thin polysilicon layer by way of an epitaxial reactor a thick semiconductor layer (3) over the buried layer (2) is deposited. By rapid thermal annealing the polycrystalline overlayer is transformed into a single crystal layer (3). The buried oxide layer (2) provides a vertical dielectrical insulation, and deep diffused or trench regions (4, 5) provide lateral junction insulation. In this manner the SOI area (3) localized between the two deep diffused regions (4, 5) is fully insulated from the silicon substrate (1). This provides the following advantages: the process can be easily integrated in standard wafer fabrication equipment and processing techniques; the process is fully compatible with many existing technologies and their process flow; and low processing cost and low density defectivity should result.

## Description

### Field of the Invention

This invention relates to lateral epitaxial growth over oxide, a known process (usually referred to by the acronym LEGO) in semiconductor manufacture.

### Background of the Invention

In the field of this invention it is known to use the lateral epitaxial growth over oxide (LEGO) method to form a localized silicon-on-insulator (SOI) structure, at low cost, with thick silicon and insulator films. Typically, in the field of Smart Power applications (i.e., semiconductor devices combining both high power functions and low voltage/power control functions), the non-SOI areas are devoted to vertical power components and the localized SOI structure provides isolation for the power components' control circuitry.

However, the LEGO method conventionally requires melting of the whole surface of a wafer, including both SOI and non-SOI areas. Clearly, melting of the non-SOI areas is undesirable and may compromise the functionality of the power components.

These problems may be avoided by use of other known techniques such as SIMOX and direct wafer bonding, but these require very expensive processing steps (e.g., high temperature and high dosage O₂ implants followed by multiple anneal cycles for SIMOX, and the joining and bonding of two substrate wafers for direct wafer bonding).

It is an object of the present invention to provide a semiconductor device and method of manufacture using lateral epitaxial growth over oxide wherein the abovementioned disadvantage(s) may be alleviated.

### Statement of Invention

In accordance with a first aspect of the present invention there is provided a semiconductor device fabricated by lateral epitaxial growth over oxide as claimed in claim 1.

In accordance with a second aspect of the present invention there is provided a method of fabricating a semiconductor device by lateral epitaxial growth over oxide as claimed in claim 7.

### Brief Description of the Drawings

One semiconductor device and method of manufacture by lateral epitaxial growth over oxide incorporating the present invention will now be described, by way of example only, with reference to the accompanying drawing(s), in which:
FIG. 1 is a cross-sectional view of a SOI structure incorporating the present invention; and
FIGS. 2-14 are cross-sectional views illustrating successive stages during fabrication of the device of FIG. 1.

### Description of Preferred Embodiment

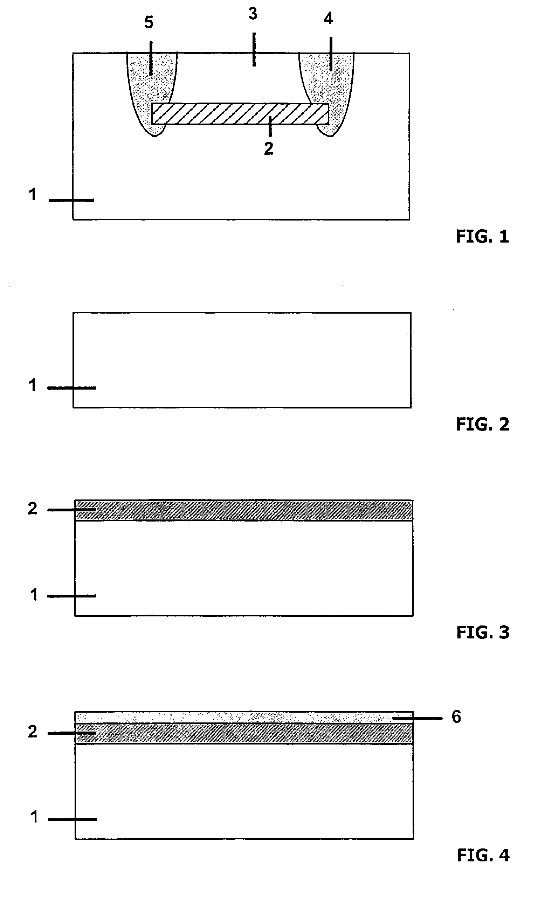

Referring now to FIG. 2, the structure 100 is formed from a substrate of starting material 1, which is preferably comprised of silicon. Preferably, the substrate 1 is of a <100> crystal orientation.

As shown in FIG. 3, at an early stage of fabrication a dielectric layer 2, for example of thermal oxide, is formed over the surface of the substrate. The thermal oxidation process comprises successive dry, wet and dry stages, resulting in a stack of successive individual oxide layers which together constitute the oxide layer 2. The dry deposition steps provide good insulation capabilities to the oxide layer, and the wet deposition step permits an increase in the process deposition rate. Generally, oxide layer 2 is of the order of 1 to 2 micron thick, and is deposited at approximately 1,150°C with a growth rate of approximately 30 Angstroms/minute.

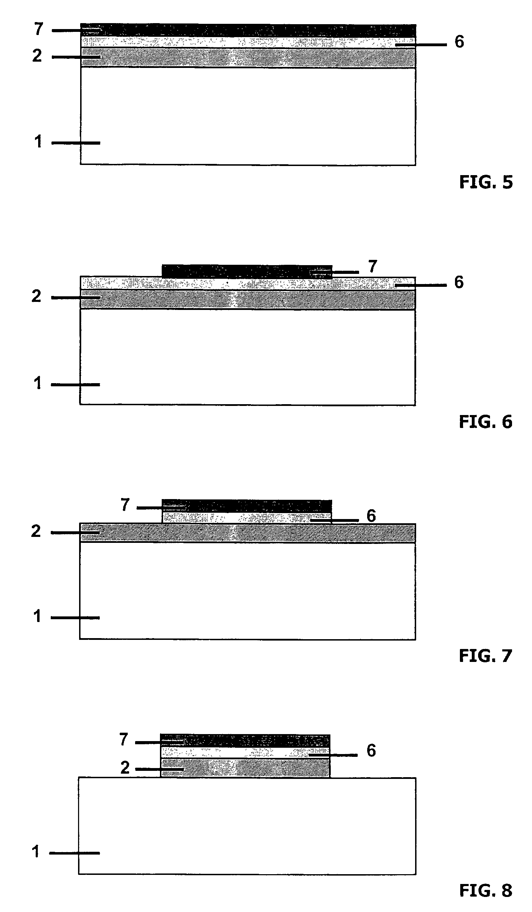

As shown in FIG. 4, at a later stage of fabrication a thin polycrystalline semiconductor layer 6 is formed over the thermal oxide layer 2. The thin polycrystalline semiconductor layer 6 is deposited by low pressure chemical vapor deposition (LPCVD). The polycrystalline layer 6 is preferably undoped polysilicon, deposited using silane at approximately 600°C with a growth rate of 100 Angströms/minute. The polysilicon layer 6 is approximately 3000 Angstroms thick.

As shown in FIG. 5, at a further stage of fabrication a photoresist layer 7 is deposited onto the polycrystalline semiconductor layer 6 using standard photoresist dispensing techniques. Preferably, the photoresist layer 7 is a positive photoresist such as AZ 1529 containing 2-Methoxy-1-methylethylacetate from Clariant GmbH of Germany. After the photoresist layer 7 is deposited, the layer is soft baked at a low temperature to dehydrate and remove excess solvents. Next, the photoresist layer 7 is selectively exposed to light using a photomask (not shown).

As shown in FIG. 6, after exposure, the photoresist layer 7 is developed in order to selectively remove photoresist from the layer 7 to form a desired pattern. To develop positive photoresist, a developer containing sodium metasilicate such as AZ developer from Clariant GmbH of Germany is used. Then the developed photoresist layer 7 is soft baked at a higher temperature.

Next, as shown in FIG. 7, the polycrystalline semiconductor layer 6 is etched to conform to the pattern provided by the remaining photoresist layer 7. The polysilicon layer 6 is etched using a reactive ion etch (RIE) system.

As shown in FIG. 8, after the polycrystalline semiconductor layer 6 is etched, the thermal oxide layer 2 is chemically etched. The thermal oxide film 2 is etched to conform to the pattern provided by the remaining photoresist layer 7, using a chemical etchant solution containing ammonium fluoride and hydrofluoric acid from Merck S.A. for example. As can be seen in FIG. 8, the etched oxide layer 2 thus has left and right edges which are laterally inwardly spaced from the edges of the substrate and which define an exposed area (on left and right) between the oxide layer 2 and the edges of the substrate 1.

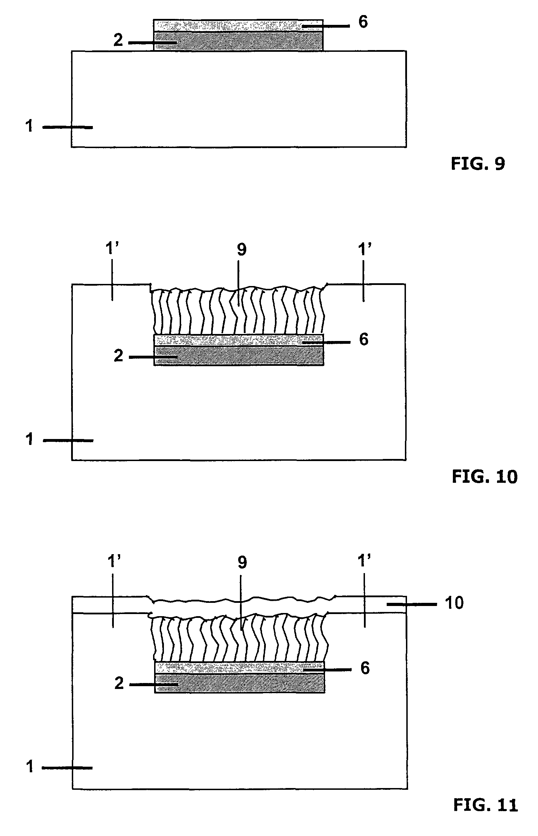

The remaining photoresist layer 7 is removed, as shown in FIG. 9, using a conventional solvent etchant. The substrate 1 is then rinsed using de-ionized water and dried.

As shown in FIG. 10, a thick semiconductor layer (9 and 1') is deposited over the entire structure surface. The thick semiconductor layer (9 and 1') is deposited using epitaxial growth and is of the order of 10 to 30 microns thick. Preferably, the thick semiconductor layer (9 and 1') is deposited using trichlorosilane at approximately 1,110°C at atmospheric pressure with a growth rate of approximately 1.5 micron/minute. The semiconductor layer (9 and 1') deposited by epitaxial growth is preferably of the same conductivity type as the substrate 1 and with the same doping. As shown in FIG. 10, the epitaxial growth over the polycrystalline semiconductor layer 6 gives a polycrystalline area 9, and over the substrate 1 the epitaxial growth gives a single crystal zone 1'. The present invention provides more particularly two different regions: the polycrystalline zone 9 and the single crystal zone 1'.

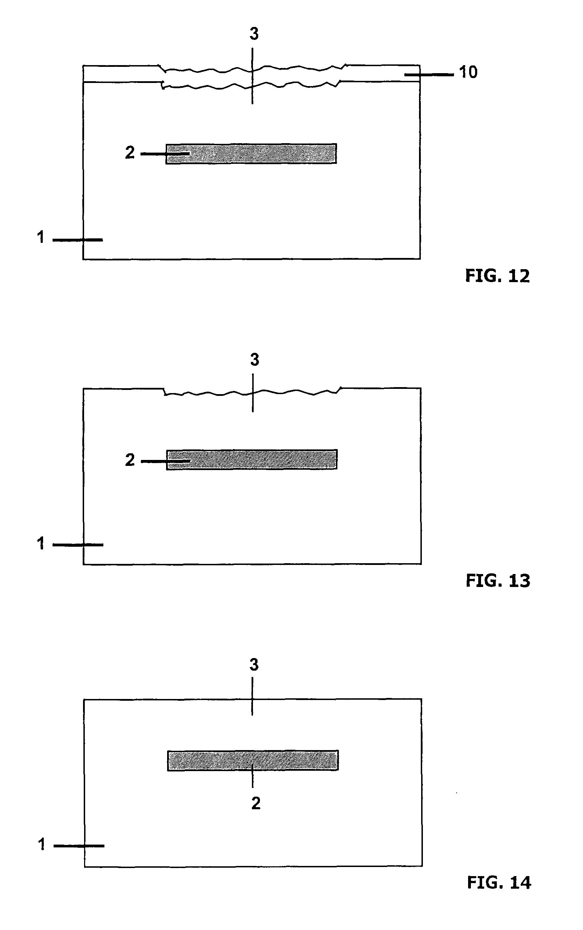

As shown in FIG. 11, at a later stage in fabrication, after the epitaxial growth of the semiconductor layer 9 over the oxide layer 2, an oxide film 10 is deposited by low pressure chemical vapor deposition (LPCVD), using silane and oxygen at approximately 340°C with a growth rate of approximately 300 Angströms/minute. The oxide layer 10 is of the order of 1 to 2 microns thick.

As shown in FIG. 12, in the final stages of fabrication, after the deposition of the cap oxide layer 10, the substrate 1 is placed into a rapid thermal reactor. Using a vertical thermal gradient, the polycrystalline area 9 over the oxide layer 2 is melted at approximately 1,412°C and recrystallized during the freezing step of rapid thermal annealing. It is to be noted that rapid thermal annealing affects only the polycrystalline zone 9 localized over the oxide layer 2 without modifying the single crystal area 1'. The single crystal zone 1' over the substrate 1 is not melted. The rapid thermal annealing provides a single crystal zone 3 over the oxide layer 2.

As shown in FIG. 13, the cap oxide layer 10 is removed using a chemical wet etch such as hydrofluoric acid etch.

As shown in FIG. 14, at the end of fabrication, the semiconductor layer 3 is planarized using a chemical-mechanical-polishing. After planarization, semiconductor material 3 with a thickness of the order of 5 to 20 microns thick is left over the oxide layer 2.

The SOI structure is then subjected to a diffusion process in which the deep junction diffusion or trench regions 4 and 5 are formed, extending from the top surface to left and right edges of the oxide layer 2, to produce the structure shown in FIG. 1. It will be appreciated that the region between the oxide layer 2 and the diffusion regions 4 and 5 is dielectrically isolated from the remainder of the substrate and may therefore be used to provide control circuitry for power components in the remainder of the substrate.

It will be understood that the semiconductor device and method of manufacture using lateral epitaxial growth over oxide described above provides the following advantages:
- the process can be easily integrated in standard wafer fabrication equipment and processing techniques;
- the process is fully compatible with CMOS, Smartmos, SmartPower and analog technologies and their process flow; and
- low processing cost and low density defectivity should result.

## Claims

1. A semiconductor device fabricated by lateral epitaxial growth over oxide, comprising:
a substrate (1) of semiconductor material having a predetermined conductivity type and a predetermined doping;
a layer (2) of dielectric material extending laterally within the substrate, the layer of dielectric material having a lateral edge remote from an adjacent edge of the substrate; and
an epitaxially grown layer of single crystal semiconductor material extending laterally across the substrate and extending perpendicularly from the layer of dielectric material, the layer of single crystal semiconductor material having:
a first single crystal portion (1') overlying the area between the lateral edge of the layer of dielectric material and the adjacent edge of the substrate, and
a second single crystal portion (9) overlying the layer of dielectric material and formed from re-crystallisation of polycrystalline material without melting of the first portion.

2. The semiconductor device according to claim 1, wherein the layer (2) of dielectric material comprises oxide.

3. The semiconductor device according to claim 2, wherein the layer (2) of dielectric material comprises stacked layers of oxide.

4. The semiconductor device according to claim 1, 2 or 3, wherein the layer of single crystal material is of semiconductor material having the same conductivity type and the same doping as the substrate.

5. The semiconductor device according to claim 1, 2, 3 or 4, further comprising first (4) and second (5) deep diffusion regions extending through the layer of single crystal material from a surface of the substrate to respective separated parts of the layer of dielectric material.

6. The semiconductor device according to any preceding claim wherein the semiconductor material of the substrate (1) and of the layer of single crystal material is silicon.

7. A method of fabricating a semiconductor device by lateral epitaxial growth over oxide, comprising:
providing a substrate (1) of semiconductor material having a predetermined conductivity type and a predetermined doping;
providing a layer (2) of dielectric material extending laterally within the substrate, the layer of dielectric material having a lateral edge remote from an adjacent edge of the substrate; and
growing an epitaxial layer of crystalline semiconductor material extending laterally across the substrate and extending perpendicularly from the layer of dielectric material, the layer of crystalline semiconductor material having:
a first portion (1') of single crystal material overlying the area between the lateral edge of the layer of dielectric material and the adjacent edge of the substrate, and
a second portion (9) of polycrystalline material overlying the layer of dielectric material; and
re-crystallising the second portion (9) of polycrystalline material into single crystal material without melting of the first portion of single crystal material.

8. The method according to claim 7, wherein the step of providing the layer (2) of dielectric material comprises growing a layer of thermal oxide.

9. The method according to claim 7 or 8, wherein the step of re-crystallising the second portion (9) of polycrystalline material into single crystal material without melting of the first portion of single crystal material comprises rapid thermal annealing.

10. The method according to claim 9, wherein the rapid thermal annealing utilizes a thermal gradient in a direction perpendicular to the direction of lateral extension.

11. The method according to any one of claims 7-10, wherein the step of providing a layer of dielectric material comprises:
providing a layer (6) of dielectric material extending laterally across the substrate; and
patterning the dielectric layer by photoresistive etching (7) to define the area between the lateral edge of the layer of dielectric material and the adjacent edge of the substrate.

12. The method according to any one of claims 7-11, wherein the layer of crystalline material is of semiconductor material having the same conductivity type and the same doping as the substrate.

13. The method according to any one of claims 7-12, further comprising providing first (4) and second (5) deep diffusion regions extending through the layer of single crystal material from a surface of the substrate to respective separated parts of the layer (2) of dielectric material to provide dielectric isolation of the region therebetween.

14. The method according to any one of claims 7-13, wherein the semiconductor material of the substrate and of the layer of single crystal material is silicon.
